# EUROPÄISCHE PATENTSCHRIFT

(11) **EP 0 735 590 B1**
(45) Veröffentlichungstag und Bekanntmachung des Hinweises auf die Patenterteilung: **23.07.2003**
(21) Anmeldenummer: 96103580.5
(22) Anmeldetag: 07.03.1996
(51) Int. Cl.: H01L 29/732, H01L 29/36

(54) **Verfahren zum Herstellung eines bipolaren Siliziumtransistors**
Method of manufacture of a Silicon bipolar transistor
Procédé de formation d'un transistor bipolaire en silicium

(30) Priorität: 27.03.1995 DE 19511251
(43) Veröffentlichungstag der Anmeldung: 02.10.1996
(73) Patentinhaber: Infineon Technologies AG, 81669 München (DE)
(72) Erfinder: Gnannt, Klaus, Dipl.-Phys., 86391 Stadtbergen (DE); Huber, Jakob, Dipl.-Phys., 83104 Beyharting (DE)
(74) Vertreter: Zimmermann & Partner

(56) Entgegenhaltungen:
- EP-A- 0 018 520
- EP-A- 0 137 645
- EP-A- 0 378 164
- US-A- 4 379 727
- PATENT ABSTRACTS OF JAPAN vol. 8, no. 200 (E-266), 13.September 1984 & JP-A-59 087856 (TOSHIBA K.K.), 21.Mai 1984,
- Physics & Technology of Semiconductor Devices A.Grove, pub. J.Wiley 1967, p.38-39,49-51
- Solid State Devices Manual pub. RCA Corp. 3/75, p.86-89

## Beschreibung

Die Erfindung bezieht sich auf einen Verfahren zum Herstellen eines bipolaren Si-Transistors mit mindestens einem mit Arsen n⁺-dotierten Emittergebiet.

Ein solcher Si-Transistor ist beispielsweise aus W. von Münch, Einführung in die Halbleitertechnologie, Teubner-Verlag, Stuttgart 1993, Seiten 208 und 209, bekannt. Darin ist ein bipolarer Silizium-Hochfrequenztransistor mit einer kammförmigen As-dotierten Emitterstruktur beschrieben. Die Emittergebiete weisen ein sehr steiles Dotierprofil mit einer geringen Eindringtiefe (< 0,6 µm) auf. Diese Eigenschaften sind für die Hochfrequenztauglichkeit des Transistors von wesentlicher Bedeutung.

Der Vorteil des Dotierstoffes Arsen beruht auf seiner geringen und konzentrationsabhängigen Diffusionsgeschwindigkeit, die die Herstellung der oben beschriebenen Dotierprofile ermöglicht. Als Verfahren zur Herstellung solcher Dotierprofile wird häufig die Ionenimplantation angewendet, wie zum Beispiel in des EP 0 378 164 A2 beschrieben. An der Verfahren zur Herstellung von Bipolartransistoren sind zum Beispiel in des EP 0 137 645 A2 und EP 0 018 520 A1 genannnt.

Bei sehr hohen Implationsdosen, wie sie beispielsweise für den Emitter eines HF-Transistors notwendig sind, verbleiben im Siliziumkristall jedoch nach einem für das oben beschriebene Dotierprofil anwendbaren Ausheilprozeß Kristallschäden, die oft zu einer Beeinträchtigung der Funktionseigenschaften des Transistors führen. So verursachen beispielsweise Kristalldefekte, die im Bereich des Emitters liegen, erhöhte Leckströme über die Emitter-Basis-Diode. Außerdem erhöht sich durch Kristalldefekte im Bereich des Emitters die Rekombination im Emittervolumen, wodurch die Stromverstärkung absinkt. Diese Absenkung der Stromverstärkung wirkt sich bei kleinen Strömen vergleichsweise stark aus, was zu einem nichtlinearen Verlauf der Stromverstärkung über dem Betriebsstrom führt. Darüberhinaus können Kristallschäden sogar die Funktion der Kollektor-Basis-Diode beeinträchtigen.

In der Halbleitertechnologie ist es allgemein üblich, durch Ausheilen bei ausreichend hohen Temperaturen die Anzahl und die elektrische Wirksamkeit von Kristalldefekten zu verringern. Für das oben beschriebene Dotierprofil gibt es jedoch keine perfekten Ausheilprozesse, da die Forderung nach einem großen Gradienten des Abfalls der As-Dotierungskonzentration im Inneren des Si-Kristalls und die Forderung nach einer geringen Eindringtiefe der As-Dotierung die Anwendung von ausreichend hohen Temperaturen und/oder langen Ausheilzeiten nicht zuläßt. Die Fehlerhäufigkeit bei den bekannten Si-Transistoren mit einem mit As n⁺-dotierten Emitter sind daher sehr hoch, was eine geringe Produktionsausbeute zur Folge hat.

Der vorliegenden Erfindung liegt daher die Aufgabe zugrunde, einen Silizium-Transistor zu entwickeln, dessen Emittergebiet trotz einer hohen Arsen-Dotierungskonzentration eine geringe Anzahl von Kristalldefekten im Siliziumkristall aufweist, ohne daß derart lange Ausheilzeiten notwendig sind, daß sich das Dotierprofil wesentlich verändert.

Diese Aufgabe wird durch ein Verfahren gemäß Anspruch 1 gelöst.

Die Zugabe einer geringen Menge Phosphor bewirkt, daß im Siliziumkristall weniger Versetzungen und weniger mechanische Verspannungen entstehen. Folglich ist auch die Wahrschein lichkeit einer Schädigung eines Transistors durch Kristalldefekte deutlich vermindert.

Die Erfindung wird anhand eines Ausführungsbeispiels in Verbindung mit den Figuren 1 bis 6 näher erläutert. Es zeigen
Figur 1 eine schematische Darstellung eines Querschnitts durch einen erfindungsgemäßen bipolaren Silizium-Transistor,
Figur 2 ein Arsen- und ein Phosphor-Dotierungsprofil eines n⁺-dotierten Emitters eines erfindungsgemäßen bipolaren Silizium-Transistors,
Figuren 3 bis 6 eine schematische Darstellung eines Verfahrens zum Herstellen einer erfindungsgemäßen bipolaren Siliziumtransistors.

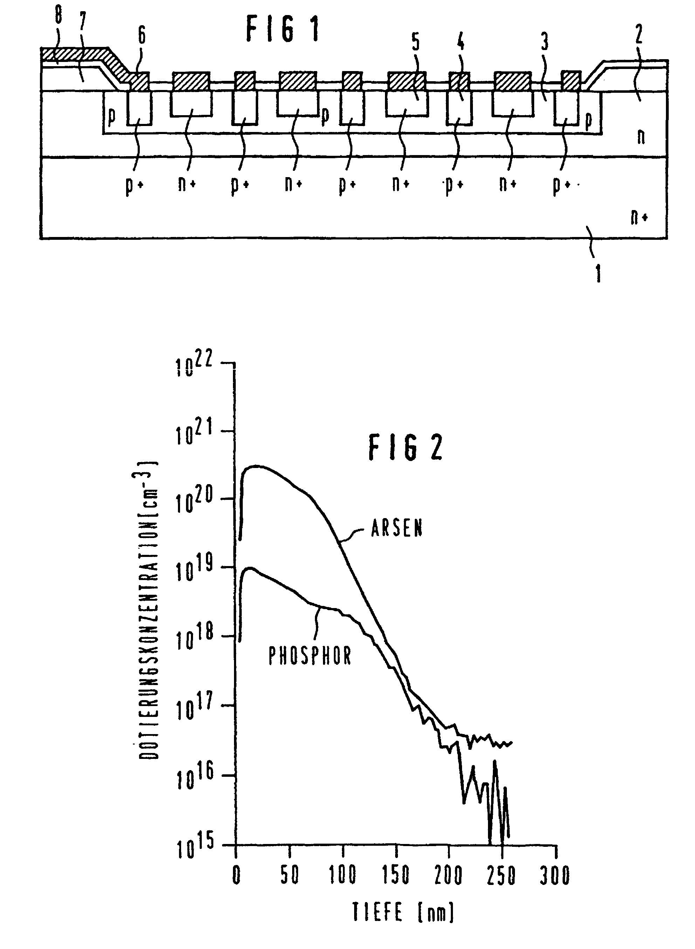

Der bipolare Silizium-Transistor von Figur 1 ist auf einem n⁺-dotierten Siliziumsubstrat 1 ausgebildet. Auf dem Siliziumsubstrat 1 ist eine Kollektorschicht 2 aus n-dotiertem Silizium beispielsweise mittels Epitaxie aufgebracht. In der Kollektorschicht 2 ist ein p-dotiertes Basisgebiet 3 eingebettet. Die Eindringtiefe des Basisgebietes ist etwa 0,5 µm. Das p-dotierte Basisgebiet 3 ist beispielsweise mit Bor dotiert. In dem p-dotierten Basisgebiet 3 sind p⁺-dotierte Basiskontaktzonen 4 und n⁺-dotierte Emittergebiete 5 eingebettet. Die p⁺-dotierten Basiskontaktzonen 4 sind beispielsweise mit Bor dotiert und die n⁺-dotierten Emittergebiete sind mit Arsen und Phosphor dotiert. Die n⁺-dotierten Emittergebiete weisen beispielsweise etwa 15 nm unterhalb der Oberfläche des Emittergebietes eine Peak-Arsen-Dotierungskonzentration von etwa 3e20 cm⁻³ und eine Peak-Phosphor-Dotierungskonzentration von etwa 1e19cm⁻³ auf. Die metallurgische Eindringtiefe der Emittergebiete 5, definiert durch die Lage des Basis-Emitter-pn-Überganges, ist etwa 0,25 µm. Auf den Basiskontaktzonen 4 und den Emittergebieten 5 sind Anschlußmetallisierungen 6, beispielsweise aus einer Gold/Platin/Titan-Legierung, aufgebracht.

Figur 2 zeigt das Arsen-Dotierungsprofil und das Phosphor-Dotierungsprofil der Emittergebiete 5. Die Arsen-Dotierungskonzentration sinkt, ausgehend von der Peak-Arsen-Dotierungskonzentration von etwa 3e20 cm⁻³ innerhalb von etwa 80 nm nur um eine Zehnerpotenz auf etwa 3e19 cm⁻³ ab. Anschließend sinkt sie innerhalb von etwa 130 nm um 3 Zehnerpotenzen auf etwa 3e16 cm⁻³ ab. Die Phospor-Dotierungskonzentration sinkt, ausgehend von der Peak-Phosphor-Dotierungskonzentration von etwa 1e19 cm⁻³ innerhalb von etwa 120 nm um eine Zehnerpotenz auf etwa 1e18 cm⁻³ ab. Anschließend sinkt sie innerhalb von etwa 80 nm um etwa 2 Zehnerpotenzen auf etwa 2e16 cm⁻³ ab. Das Phosphor-Dotierprofil hat keinen wesentlichen Einfluß auf die Charakteristik des des Basis-Emitter-pn-Überganges.

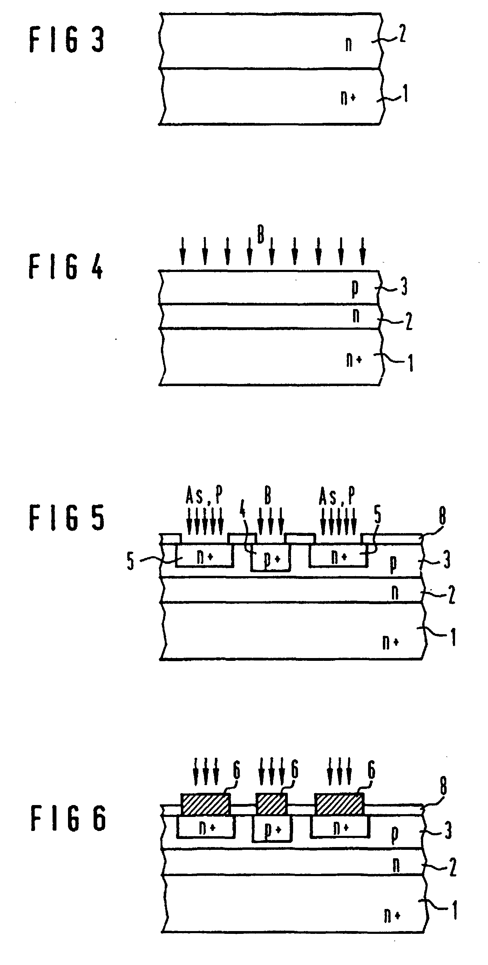

Das in den Figuren 3 bis 6 schematisch dargestellte Verfahren zur Herstellung des oben beschriebenen bipolaren Silizium-Transistors weist beispielsweise folgende aufeinanderfolgende Schritte auf:
a) epitaktisches Aufbringen der n-dotierten Kollektorschicht 2 auf das n⁺-dotierte Substrat 1 (Fig. 3);
b) Herstellen des p-dotierten Basisgebietes 3 durch Implantation von Bor und anschließendes Ausheilen (Fig. 4);
c) Abscheiden isolierender Schichten 7, 8 aus Siliziumoxid und/oder Siliziumnitrid mit streifenförmigen Fenstern für die Basiskontaktzonen 4 und die Emittergebiete 5 (Fig. 5);
d) Implantieren von Bor in die Basiskontaktzonen 4 (Fig. 5);
e) Implantieren einer Arsen-Dosis von zwischen 2e15 cm⁻² und 1e16 cm⁻² mit einer Energie von bis zu 50 keV und Implantieren einer Phosphordosis von zwischen 1e13cm⁻² und 5e14cm⁻² mit einer Energie von kleiner als 25keV in die Emittergebiete 5 (Fig. 5);
f) Ausheilen der Implantationsschäden durch Tempern bei 900°C mit einer Dauer von etwa 10 Minuten;
g) Aufdampfen der Anschlußmetallisierung 6 (Fig. 6).

Das Ausheilen kann alternativ zu dem in Punkt f) angegebenen Verfahren mittels eines sogenannten Schnell-Ausheilungsverfahrens (RTA = Rapid Thermal Annealing) durchgeführt werden. Dabei wird der Si-Transistor in einer Kammer mit leistungsstarken Lampen, deren Licht auf den Si-Transistor konzentriert wird, innerhalb von wenigen Sekunden auf über 1000°C erhitzt, kurzzeitig bei dieser hohen Temperatur belassen und anschließend wieder schnell abgekühlt. Ebenso kann eine Kombination aus diesem Verfahren und dem unter Punkt f) genannten Ofenprozeß angewendet werden.

## Patentansprüche

1. Verfahren zur Herstellung eines bipolaren Siliziumtransistors mit mindestens einem mit Arsen n⁺-dotierten Emittergebiet (5), wobei das mit Arsen n⁺-dotierte Emittergebiet zusätzlich eine Phosphor-Dotierung aufweist und das Verhältnis Arsen-Dotierungskonzentration:Phosphor-Dotierungskonzentration zwischen 10:1 und 500:1 liegt,
wobei auf ein Siliziumsubstrat (2) isolierende Schichten (7, 8) aus Siliziumoxid und/oder Siliziumnitrid mit streifenförmigen Fenstern für die Basiskontaktzonen (4) und das n⁺-dotierte Emittergebiet (5) abgeschieden werden,
Bor zur Bildung der Basiskontaktzonen (4) in das Siliziumsubstrat (2) implantiert wird,
das n⁺-dotierte Emittergebiet (5) mittels Arsen-Implantation und anschließender Phosphor-Implantation in das Siliziumsubstrat (2) ohne Änderung der Streifenförmigen Fenster hergestellt wird, und anschließend Kristalldefekte ausgeheilt werden.

2. Verfahren nach Anspruch 1,
**durch gekennzeichnet, daß**
Arsen mit einer Dosis von zwischen 2e15cm⁻² und 1e16cm⁻² mit einer Energie von bis zu 50 keV und Phosphor mit einer Dosis von zwischen 1e13cm⁻² und 5e14cm⁻² mit einer Energie von kleiner als 25keV implantiert wird.

3. Verfahren nach Anspruch 1 oder 2,
**dadurch gekennzeichnet, daß**
das Ausheilen der Implantationsschäden durch Tempern bei 900°C mit einer Dauer von etwa 10 Minuten oder mittels eines sogenannten Schnell-Ausheilungsverfahrens, RTA = Rapid Thermal Annealing, durchgeführt wird.

## Claims

1. Method for fabricating a bipolar silicon transistor having at least one emitter region (5) which is n⁺-doped with arsenic, the emitter region which is n⁺-doped with arsenic additionally having a phosphorus doping and the ratio of arsenic doping concentration: phosphorus doping concentration lying between 10:1 and 500:1,
in which case
insulating layers (7, 8) made of silicon oxide and/or silicon nitride with strip-shaped windows for the base contact zones (4) and the n⁺-doped emitter region (5) are deposited onto a silicon substrate (2),
boron, for forming the base contact zones (4), is implanted into the silicon substrate (2),
the n⁺-doped emitter region (5) is fabricated by means of arsenic implantation and subsequent phosphorus implantation into the silicon substrate (2) without changing the strip-shaped windows, and
crystal defects are subsequently annealed.

2. Method according to Claim 1,
**characterized in that**
arsenic is implanted with a dose of between 2e15cm⁻² and 1e16cm⁻² with an energy of up to 50 keV and phosphorus is implanted with a dose of between 1e13cm⁻² and 5e14cm⁻² with an energy of less than 25 keV.

3. Method according to Claim 1 or 2,
**characterized in that**
the annealing of the implantation damage is carried out by heat treatment at 900°C with a duration of about 10 minutes or by means of a so-called rapid annealing method, (RTA = Rapid Thermal Annealing).

## Revendications

1. Procédé de production d'un transistor bipolaire au silicium ayant au moins une zone (5) d'émetteur à dopage de type n⁺ par de l'arsenic, la zone d'émetteur à dopage de type n⁺ par de l'arsenic ayant en plus un dopage au phosphore et le rapport de la concentration de dopage de l'arsenic à la concentration de dopage au phosphore étant compris entre 10:1 et 500:1, dans lequel on dépose sur un substrat (2) en silicium des couches (7, 8) isolantes en oxyde de silicium et/ou en nitrure de silicium ayant des fenêtres en forme de bandes pour les zones (4) de contact de la base, et pour la zone (5) d'émetteur à dopage de type n⁺,
on implante du bore pour la formation des zones (4) de contact de la base dans le substrat (2) en silicium,
on produit la zone (5) d'émetteur à dopage de type n⁺ au moyen d'une implantation d'arsenic et ensuite d'une implantation de phosphore dans le substrat (2) en silicium sans modification des fenêtres en forme de bandes, et
ensuite, on cicatrice des défauts cristallins.

2. Procédé suivant la revendication 1, **caractérisé en ce que** l'on implante de l'arsenic en une dose comprise entre 2e15 cm⁻² et 1e16 cm⁻² à une énergie allant jusqu'à 50 keV, et du phosphore en une dose comprise entre 1e13 cm⁻² et 5e14 cm⁻² à une énergie inférieure à 25 keV.

3. Procédé suivant la revendication 1 ou 2, **caractérisé en ce que** l'on effectue la cicatrisation des dommages dus à l'implantation par traitement thermique à 900°C d'une durée de 10 minutes environ ou au moyen de ce que l'on appelle un procédé de cicatrisation rapide, RTA = Rapid Thermal Annealing.
